# EUROPÄISCHE PATENTSCHRIFT

(11) **EP 3 884 740 B1**
(45) Veröffentlichungstag und Bekanntmachung des Hinweises auf die Patenterteilung: **16.10.2024**
(21) Anmeldenummer: 19805269.8
(22) Anmeldetag: 15.11.2019
(51) Int. Cl.: H05K 1/03, H05K 3/10, H05K 3/30

(54) **ELEKTRISCHE VERBINDUNG AUF EINEM TEXTILEN TRÄGERMATERIAL**
ELECTRIC CONNECTION ON A TEXTILE CARRIER MATERIAL
CONNEXION ÉLECTRIQUE SUR UN MATÉRIAU SUPPORT TEXTILE

(30) Priorität: 20.11.2018 AT 510182018
(43) Veröffentlichungstag der Anmeldung: 29.09.2021
(73) Patentinhaber: Adaptive Regelsysteme Gesellschaft m.b.H., 5020 Salzburg (AT); Texible GmbH, 6850 Dornbirn (AT); "Zaza" Textillösungen GmbH, 6842 Koblach (AT)
(72) Erfinder: KLAPPER, Ulrich, 6830 Rankweil (AT); FRÖIS, Thomas, 6832 Sulz (AT); REPNIK-HOTZ, Monika, 6845 Hohenems (AT)
(74) Vertreter: Patentanwälte Pinter & Weiss OG
(86) Internationale Anmeldenummer: PCT/EP2019/081481
(87) Internationale Veröffentlichungsnummer: WO 2020/104323

(56) Entgegenhaltungen:
- EP-A1- 3 100 677
- WO-A2-99/60829
- CN-A- 108 517 605
- US-A1- 2003 211 797
- US-A1- 2005 095 406

## Beschreibung

Die gegenständliche Erfindung betrifft ein Verfahren zur Herstellung einer elektrisch leitenden Verbindung zwischen einem ersten Leitelement und einem zweiten Leitelement auf einem textilen Trägermaterial, wobei das erste und zweite Leitelement auf dem Trägermaterial angeordnet werden, im Bereich des ersten und zweiten Leitelements ein elektrisch leitender Thermotransferklebstoff angeordnet wird und der Thermotransferklebstoff bis zur Fließbarkeit aufgeschmolzen wird, sodass der fließbare Thermotransferklebstoff das erste und zweite Leitelement zumindest teilweise umgibt und sich mit dem Trägermaterial verbindet und das erste Leitelement und das zweite Leitelement nach dem Aushärten des Thermotransferklebstoffes über den Thermotransferklebstoff elektrisch miteinander verbunden werden.

Als intelligente Kleidung, oder Smart Textile, werden Kleidungsstücke mit integrierter, mitunter auch von außen nicht sichtbarer, Elektronik oder Elektrik bezeichnet. Mit der Elektronik oder Elektrik können nahezu beliebige Funktionen realisiert werden, wie beispielsweise leuchtende Kleidung, Spielfunktionen (z.B. Lasertagging), Überwachung von Vitalparametern (z.B. Herzfrequenz, Blutdruck, Körpertemperatur, Atemfrequenz, Elektrokardiogramm (EKG), usw.), Sicherheitsfunktionen (z.B. um elektrische Spannungen zu detektieren, Falldetektoren, usw.), Kommunikation, Multimedia, etc. In vielen dieser Anwendungen ist es erforderlich, elektrische Leiter an der intelligenten Kleidung miteinander zu verbinden, beispielsweise um eine Leuchtdiode mit Leitern, die den Strom von anderer Stelle zu den Pins der Leuchtdiode transportiert, zu verbinden. Ein anderes Beispiel ist das Verbinden eines Sensors mit einer Steuereinheit. Ebenso ist oftmals auch erforderlich die Elektronik mit einer elektrischen Energieversorgung zu verbinden. Zusätzlich muss aber auch oft eine mechanische Befestigung oder Verbindung erzeugt werden.

Elektrische Verbindungen zwischen Drähten und elektrischen Kontakten werden außerhalb der Smart Textile Industrie häufig durch Löt- oder Krimpverbindungen hergestellt. Diese Verbindungen sind aber in smarten Textilien aus verschiedenen Gründen nicht optimal: Die Verfahren sind gänzlich neu für die Textilindustrie, die Verfahren sind nicht gut beständig in Waschvorgängen, welchen Textilien unterworfen werden und die Verfahren sind verhältnismäßig aufwändig in der Durchführung. Abgesehen davon ist es nachvollziehbar ungünstig auf einem textilen Material eine Lötstelle auszubilden, da dadurch das textile Material leicht beschädigt oder sichtbar beeinträchtigt werden kann. Auch Krimpverbindungen sind aufgrund der Größe solcher Verbindungen auf intelligenten Kleidungsstücken eher ungünstig, sowohl hinsichtlich der Optik, als auch des Tragekomforts.

Bekannt sind in der Textilindustrie Thermotransferverfahren, auch Hot-Melt-Adhesive Verfahren genannt. Es kommen Netze oder Vliese aus Thermotransfermaterial, beispielsweise PLATAMID (von Arkema) oder DYNACOLL S (von Evonik), zum Einsatz die zwischen zwei Schichten Stoff gelegt werden können. Wird das Paket aus dem oberen Stoff, dem Thermotransfernetz und dem unteren Stoff kurz erhitzt und verpresst, dies kann mit einem Bügeleisen oder auch einer Thermotransferpresse erfolgen, schmilzt das Thermotransfernetz teilweise auf und es werden die zwei Stoffe nach dem Aushärten des Thermotransfernetzes langlebig und prozesssicher miteinander verbunden. Für elektrische Verbindungen sind solche Verfahren aber ungeeignet, weil die beteiligten Materialien keine elektrischen Leiteigenschaften haben.

Aus der EP 1 489 696 A2 ist ein Verfahren bekannt, bei denen isolierte Leiter die nur stellenweise abisoliert sind (längs oder nur an den Stirnflächen) über elektrisch leitende Klebstoffe auf einem textilen Gewebe mechanisch fixiert und auch elektrisch verbunden werden. Vorgeschlagen werden zu diesem Zweck herkömmliche Klebstoffe aber auch silbergefülltes Epoxidharz. In Nähereien mit flüssigen Klebstoffen, oder gar Vergussmassen zu arbeiten erscheint aber höchst aufwändig. Die mit diesen Verfahren hergestellten Verbindungen sind für den textilen Alltag möglicherweise auch nicht prozesssicher genug.

Aus der WO 2005/045110 A1 ist bekannt, wie isolierte Leiter auf textile Werkstoffe mit adhäsiven Bändern aufgebracht und fixiert werden können. Es wird in der vorgestellten Erfindung auch mit Thermotransferklebern gearbeitet. Die elektrische Verbindung am Ende des Leiters wird aber nicht erklärt, es ist lediglich von einem "Connector" am Ende des Leiters die Rede.

Aus der US 2003/211797 A1 ist es bekannt, einen Schaltkreisträger, auf dem ein Thermotransferkleber aufgetragen ist, bei der Herstellung eines Gewebes in das Gewebe einzuweben, also den Schaltkreisträger in das textile Trägermaterial bereits bei der Herstellung des Gewebes zu integrieren. Unmittelbar nach dem Webvorgang wird der Thermotransferkleber durch beheizte Rollen aktiviert, um eine feste Verbindung des Schaltkreisträgers im Gewebe zu bewirken. Das ist allerdings ein sehr aufwendiges Herstellverfahren und ermöglicht insbesondere nicht, ein Bekleidungsstück aus dem Gewebe nachträglich zu einer intelligenten Kleidung zu machen.

CN 108517605 A beschreibt ein Heizgewebe, in das leitfähige Fasern eingewebt sind. Die Enden sind an einer positiven Elektrode und einer negativen Elektrode elektrisch miteinander verbunden. Die Elektroden werden durch einen elektrisch leitfähigen Heißklebstoff ausgebildet, wobei der Heißkleber direkt aufgebracht wird. Ein derartiger direkter Auftrag des Heißklebers auf das Gewebe ist bei der Verarbeitung von Textilen aber wieder ungünstig.

Ebenfalls bekannt sind Verfahren bei denen elektrische Leiter auf textile Trägermaterialien mittels Plotter oder diversen Druckverfahren aufgebracht werden.

Es ist daher eine Aufgabe der gegenständlichen Erfindung, eine einfache und sichere Verbindung zwischen zwei oder mehreren elektrischen Leitern auf einem textilen Trägermaterial herzustellen.

Die Aufgabe wird erfindungsgemäß durch die Merkmale von Anspruch 1 gelöst. Durch die Verwendung eines elektrisch leitend gemachten Thermotransferklebstoffes kann das im Umfeld von Textilien technisch sehr einfach beherrschbare Thermotransferverfahren zur Herstellung der elektrischen Verbindung genutzt werden. Nachdem der Thermotransferklebstoff bei normalen Raumtemperaturen in der Regel keine Hafteigenschaften hat, kann dieser auch einfach und sauber verarbeitet werden, was insbesondere bei Textilien vorteilhaft ist. Gleichzeitig werden die Leitelemente über den Thermotransferklebstoff auch mechanisch am textilen Trägermaterial fixiert. Damit können in einem Arbeitsschritt zwei grundsätzliche Probleme im Zusammenhang mit elektrischen Verbindungen auf textilen Kleidungsstücken gelöst werden.

In einer erfindungsgemäßen Ausführung ist ein flächiger Patch vorgesehen, wobei der Thermotransferklebstoff zwischen dem Trägermaterial und dem flächigen Patch vorgesehen ist und die Enden der Leitelemente im Bereich des Thermotransferklebstoffes zwischen dem Trägermaterial und dem flächigen Patch angeordnet sind. Für die Herstellung der elektrischen Verbindung wird ein Patch mit einem auf einer dem Trägermaterial zugewandten Seite aufgetragenen elektrisch leitenden Thermotransferklebstoff oder ein Patch mit einem Klebstoffpatch aus elektrisch leitendem Thermotransferklebstoff zwischen Patch und Trägermaterial verwendet, wobei der Patch auf das Ende des ersten Leitelements und des zweiten Leitelementes und auf das Trägermaterial aufgelegt wird, bevor der Thermotransferklebstoff unter Druckeinwirkung aufgeschmolzen wird, um die elektrische Verbindung herzustellen. Ein solcher Patch kann einfach gehandhabt werden, beispielsweise nach Belieben zugeschnitten werden und auf dem Trägermaterial platziert werden, was die Herstellung der elektrischen Verbindung weiter vereinfacht und kostengünstig macht. Die Verarbeitung kann dann sehr einfach und schnell als ein Arbeitsgang bei der textilen Produktion durchgeführt werden, indem die benötigten Leitelemente auf einem Stück textilem Trägermaterial (z.B. Stoff) angeordnet und dann mittels Patch in einer Thermotransferpresse mit Thermotransferverfahren in einem einzigen Arbeitsschritt elektrisch verbunden und mechanisch fixiert werden.

Die Möglichkeiten der Herstellung elektrischer Verbindungen können in einer weiteren erfindungsgemäßen Ausführung erweitert werden, wenn der flächige Patch an der dem Thermotransferklebstoff zugewandten Seite elektrisch leitend ausgeführt ist. Damit kann der Patch selbst als Leitelement dienen. Das ist besonders vorteilhaft, wenn der flächige Patch an der dem Trägermaterial abgewandten Seite elektrisch leitend ausgeführt ist und die dem Trägermaterial zugewandte elektrisch leitende Seite des Patches mit der dem Trägermaterial abgewandten Seite des Patches elektrisch leitend verbunden ist. Das ermöglicht es, die elektrische Verbindung auch von außen elektrisch zu kontaktieren. Der Patch kann somit als kontaktierbare Elektrode am Trägermaterial dienen. Werden zwei derartige Patches gegen zwei Pole einer Batterie gepresst, kann beispielsweise eine elektrische Schaltung im Textil einfach mit elektrischer Energie versorgt werden.

Um die hergestellte elektrische Verbindung nach außen elektrisch zu isolieren kann vorgesehen sein, dass an den Außenkanten des Patches ein über den Umfang des Patches durchgehender Bereich mit einem elektrisch nichtleitenden Thermotransferklebstoff vorgesehen ist. Durch das Thermotransferverfahren wird sowohl der elektrisch leitende Thermotransferklebstoff, als auch der umgebende elektrisch nichtleitende Thermotransferklebstoff aufgeschmolzen und appliziert, was die Herstellung der elektrischen Isolation nach außen sehr vereinfacht. In diesem Zusammenhang ist es vorteilhaft, wenn der Patch aus wasserdichtem Material hergestellt und auf einem (zumindest im Bereich der elektrischen Verbindung) wasserdichten Trägermaterial aufgebracht ist. Wird nun wie vorgesehen in der Mitte des Patches elektrisch leitfähiger Thermotransferklebstoff aufgebracht, hingegen am Rand des Patches elektrisch nichtleitender Thermotransferklebstoff, so entsteht nach einer Thermotransferpressung unter dem Patch ein nach außen wasserdicht isolierter, elektrisch leitfähiger Bereich. Bedarfsweise muss der elektrisch nichtleitende Thermotransferklebstoff dabei aber nicht über den ganzen Umfang vorgesehen sein.

In einer besonders vorteilhaften Ausgestaltung ist das zweite Leitelement als flächiger Patch ausgeführt und der Patch an der dem Trägermaterial zugewandten Seite weist zumindest drei Bereiche auf, wobei ein erster und ein zweiter Bereich mit elektrisch leitfähigem Thermotransferkleber versehen ist und ein dritter Bereich mit elektrisch nicht leitfähigem Thermotransferkleber versehen ist. Eine solche Ausführung des Patches erlaubt die einfache Realisierung von Schaltkreisen mittels geeigneter Gestaltung der leitenden und nicht leitenden Bereiche von Thermotransferklebstoff. Hierzu ist es vorteilhaft, wenn der erste und der zweite elektrisch leitfähige Bereich durch den dritten elektrisch nicht leitfähigen Bereich elektrisch voneinander isoliert sind.

Eine elektrische Schaltung mit einem elektrischen oder elektronischen Bauelement kann damit einfach realisiert werden, wenn am Patch zumindest ein elektronisches oder elektrisches Bauelement mit zumindest einem ersten und zweiten Anschlusspin angeordnet ist, wobei der erste Anschlusspin mit dem ersten elektrisch leitfähigen Bereich elektrisch leitend verbunden ist und der zweite Anschlusspin mit dem zweiten elektrisch leitfähigen Bereich elektrisch leitend verbunden ist. Am Patch können so auch mehrere Bauelemente platziert werden, die über die Anordnung der leitenden und nicht leitenden Bereiche von Thermotransferklebstoff am Patch auch einfach elektrisch verschaltet werden können.

Auch dabei kann vorgesehen sein die hergestellte elektrische Verbindung nach außen elektrisch zu isolieren, indem an den Außenkanten des Patches ein vierter über den Umfang des Patches durchgehender Bereich mit einem elektrisch nichtleitenden Thermotransferklebstoff vorgesehen wird. Auch diese Ausführung kann mit einem wasserdichten Patch und einem (zumindest im Bereich der elektrischen Verbindung) wasserdichten Trägermaterial kombiniert werden. Bedarfsweise muss der elektrisch nichtleitende Thermotransferklebstoff dabei nicht über den ganzen Umfang vorgesehen sein.

Eine weitere Vereinfachung bei der Herstellung der elektrischen Verbindung ergibt sich, wenn eine elektrische Isolierung zumindest eines Leitelements im Bereich des elektrisch leitfähigen Thermotransferklebstoffes durch das Thermotransferverfahren zumindest teilweise aufgeschmolzen ist. Damit muss ein mit einer Isolierung versehenes Leitelement zur Herstellung der elektrischen Verbindung nicht abisoliert werden. Hierzu ist vorteilhafterweise im leitfähigen Thermotransferklebstoff zwischen dem Trägermaterial und dem zumindest einen Leitelement mit Isolierung und/oder zwischen dem zumindest einen Leitelement mit Isolierung und einem Patch ein elektrisch leitender Draht im Wesentlichen quer zum Leitelement angeordnet, der das Leitelement elektrisch kontaktiert. Damit kann der Übergangswiderstand zwischen Leitelement und dem leitenden Thermotransferklebstoff verringert werden.

Der elektrisch leitende und/oder elektrisch nichtleitende Thermotransferklebstoff kann besonders einfach, genau und sauber mittels eines Druckverfahrens auf den Patch aufgebracht werden. Es können Siebdruckverfahren, Rotationsdruckverfahren, Digitaldruckverfahren, Abstandsrake- oder Breitschlitzdüsenverfahren oder auch andere Verfahren die den Effekt erzielen verwendet werden. Dabei kann es auch vorteilhaft sein, wenn ein elektrisch leitender Thermotransferklebstoff zumindest teilweise mit einem elektrisch nichtleitendem Thermotransferklebstoff (oder umgekehrt) überdruckt wird, wodurch sich mehr Möglichkeiten zur Herstellung von Schaltkreisen ergeben.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt
Fig.1 einen Schnitt durch einen Patch, der auf einem textilen Trägermaterial zwei Leiter elektrisch verbindet
Fig.2 einen Schnitt durch einen leitfähigen Patch zur elektrischen Verbindung eines drahtförmigen Leiters mit einem Gegenstand außerhalb des Textils,
Fig.3 einen Schnitt durch einen Patch mit integrierter Leuchtdiode,
Fig.4 einen Schnitt durch einen Patch mit elektrisch verbundenem isolierten Leitelement,
Fig.5 einen Schnitt durch einen Patch mit elektrisch leitenden Fasern im textilen Trägermaterial,
Fig.6 ein Ausführungsbeispiel eines Smart Textiles mit erfindungsgemäßen elektrischen Verbindungen und
Fig.7 einen Patch mit verschiedenen leitenden und nichtleitenden Bereichen des Thermotransferklebstoffes.

Textilien (textile Materialen) im Sinne der Erfindung umfassen textile Rohstoffe oder nichttextile Rohstoffe die durch verschiedene Verfahren zu flächenförmigen oder räumlichen textilen Gebilden verarbeitet wurden. Textilien aus textilen Rohstoffen können auch nichttextile Rohstoffe enthalten. Textile Rohstoffe können Naturfasern (pflanzlichen oder tierischen Ursprungs) oder Kunstfasern (aus Kunststoffen) umfassen, wie beispielsweise Baumwolle, Wolle, Polyester oder Polyamid. Nichttextile Rohstoffe können z.B. auch Leder, Federn, Schuppen oder Metalle sein. Typische flächenförmige Anordnungen sind Gewebe, Maschenware, Gewirke, Gestricke, Geflechte, Nähgewirke, Vliesstoffe oder Filze, die meistens in Form von textilen Stoffbahnen vorliegen. Räumliche Anordnungen können beispielsweise röhrenförmige Gebilde sein, ebenfalls wieder in Form von Gewebe, Maschenware, Gewirke, Gestricke, Geflechte, Nähgewirke, Vliesstoffe oder Filze. Ein textiles Material ist ausreichend flexibel, um zu einem Kleidungsstück verarbeitet zu werden oder um in einem Kleidungstück verwendet werden zu können. Gänzlich steife Materialen oder steife Materialien, die die Beweglichkeit der tragenden Person im Kleidungsstück zu weit einschränken, eignen sich hierfür nicht.

Mit der Erfindung soll auf einem textilen Trägermaterial 11 eine elektrische Verbindung zwischen zumindest zwei elektrischen Leitelementen 31, 32 zum Leiten eines elektrischen Stromes hergestellt werden. Ein elektrisches Leitelement 31, 32 kann dabei ein länglicher Leiter wie z.B. ein Draht, eine Ader, eine Litze, etc., oder auch ein flächiger Leiter, wie z.B. eine Elektrode, sein. Das elektrische Leitelement 31, 32 ist aus einem elektrisch leitfähigen Material gefertigt, beispielsweise aus Kupfer oder Aluminium, oder zumindest teilweise an der Oberfläche eines Trägerelements mit einem elektrischen leitfähigen Material, beispielsweise Kupfer, Aluminium, Gold, Silber, usw., beschichtet. Es können auch leitfähig beschichtete Garne, oder beliebige Materialien aus der Gruppe der leitenden Stoffe ausgewählt werden, z.B. leitfähige Metalldrähte, Metallfasergarne, leitfähige Kunststoffe, Carbon-Materialien oder Kombinationen oder Mischungen daraus. Das Trägerelement kann im Falle einer Beschichtung aus einem nichtleitenden Material, beispielsweise Papier, Kunststoff, Textil, Metall, usw., gefertigt sein. Auch Verbundmaterialen kommen für ein elektrisches Leitelement 31, 32 in Frage. Ein Leitelement 31, 32 kann auch Teil des textilen Trägermaterials 11 sein, beispielsweise ein im textilen Material eingewobener oder eingearbeiteter Metalldraht oder eine elektrisch leitend beschichtete Faser in einem Gewebe oder einer Maschenware.

Zur Herstellung der elektrisch leitenden Verbindung ist ein elektrisch leitender Thermotransferklebstoff vorgesehen. Ein Thermotransferklebstoff ist ein Klebstoff in Form eines Thermoplastes, der bei normalen Einsatztemperaturen eines intelligenten Kleidungsstückes, typischerweise zwischen -20°C und 60°C einen festen Zustand besitzt und üblicherweise nicht klebend ist (also keine Hafteigenschaften aufweist). Ab einer bestimmten Schmelztemperatur (Reaktionstemperatur), typischerweise zwischen 125 und 250°C, erweicht der Thermotransferklebstoff bis zur Fließbarkeit und entwickelt zusätzlich Hafteigenschaften (wird somit klebend). Bei Abkühlung härtet der Thermotransferklebstoff wieder aus und verfestigt sich wieder, wobei der Thermotransferklebstoff seine Klebrigkeit verliert. Hafteigenschaften können sich dabei auch schon unterhalb der Schmelztemperatur beginnen auszubilden. Zwei Haftpartner, die durch den Thermotransferklebstoff miteinander verbunden werden sollen, werden bei aufgeschmolzenem Thermotransferklebstoff durch Druck aneinandergepresst, sodass sich der Thermotransferklebstoff mit den beiden Haftpartnern verbindet. Nach dem Aushärten des Thermotransferklebstoffes bildet sich eine sichere und dauerhafte Verbindung zwischen den beiden Haftpartnern aus.

Der Thermotransferklebstoff kann zur Herstellung der elektrischen Verbindung auf dem Trägermaterial 11 und/oder einem Leitelement 31, 32 aufgetragen sein, beispielsweise in Pastenform aufgetragen oder aufextrudiert, oder kann in Form eines Netzes, Gewebes oder einer Folie vorliegen und an der benötigten Stelle des Trägermaterial 11 als Klebstoffpatch angelegt werden. Im letzteren Fall kann ein solches Netz, Gewebe oder eine solche Folie auch mit einem flächigen Leitelement 31, 32 kaschiert sein, also mittels eines geeigneten Haftmittels damit verbunden sein.

Um einen solchen Thermotransferklebstoff elektrisch leitend zu machen kann ein elektrisch leitendes Material, beispielsweise Graphitpulver oder ähnliche leitfähige Substanzen, zum Thermotransferklebstoff beigemengt werden. Beispielsweise kann ein kommerziell erhältliches Thermotransfermaterial als Granulat für einen Extruder vorliegen. Beim Extrudieren des Thermotransfermaterials zu einer Folie oder einer Faser kann dann das elektrisch leitende Material, das pulver- oder granulatförmig vorliegen kann, beigemischt werden, um den extrudierten Thermotransferklebstoff elektrische leitend zu machen. Aus einer derart hergestellten Faser kann dann ein Netz oder ein Gewebe aus Thermotransferklebstoff hergestellt werden. Ein pulverförmiges Thermotransfermaterial kann z.B. mit dem elektrisch leitenden Material gemischt werden, um daraus eine Paste aus Thermotransferklebstoff herzustellen. Ein pastenförmiges Thermotransfermaterial kann ebenfalls mit einem pulverförmigen oder pastenförmigen elektrisch leitenden Material gemischt werden, um das Thermotransfermaterial elektrisch leitend zu machen. Beispielhafte Marken und Hersteller von Thermotransfermaterialen sind unter anderem PLATAMID (von Arkema), DYNACOLL S (von Evonik) oder TUBILUX TD 90 NF (von CHT). Bei geeigneter Materialwahl für den Thermotransfermaterial und das elektrisch leitende Material entstehen mit einem daraus hergestellten Thermotransferklebstoff elektrische Verbindungen mit Widerständen vom weniger als 10 Ohm, vorzugsweise im Milliohmbereich.

Im nachfolgenden werden verschiedene Ausführungsbeispiele zur Herstellung einer elektrisch leitenden Verbindung auf einem textilen Trägermaterial 11 mittels eines elektrisch leitenden Thermotransferklebstoffes beschrieben.

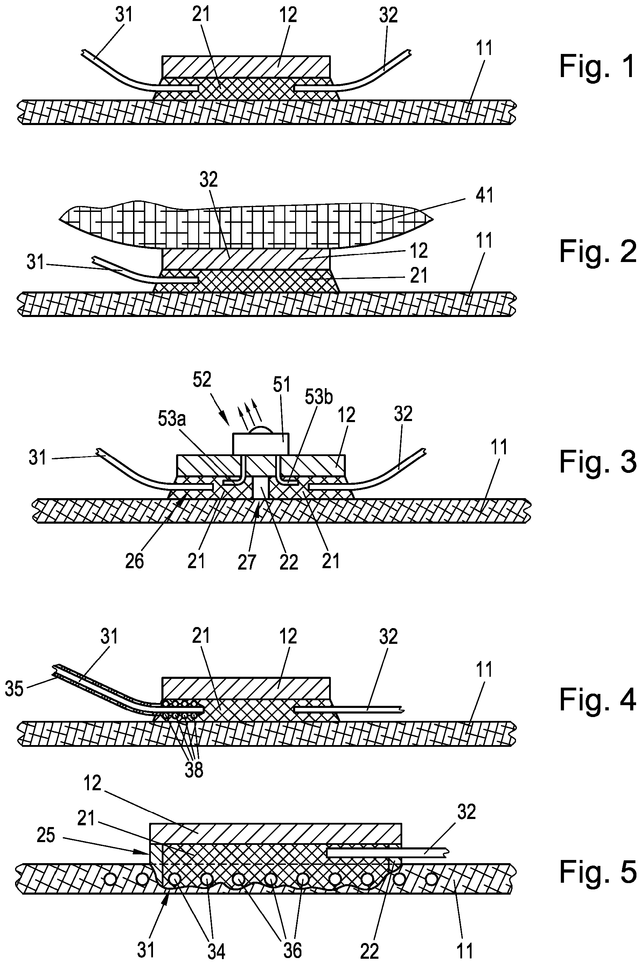

In Fig.1 ist ein textiler oder auch nicht textiler Patch (Flicken oder ein Materialstückchen) 12 mittels elektrisch leitendem Thermotransferklebstoff 21 auf ein textiles Trägermaterial 11 aufgebracht. Der Patch 12 kann aus einem textilen Material gefertigt sein, oder auch aus Kunststoff oder Metall. Der Patch 12 ist ein ausreichend großes flächiges Materialstück, um zumindest den Bereich der elektrischen Verbindung abzudecken, und ist in der Regel wesentlich kleiner als das Trägermaterial 11. Die Leitelemente 31, 32 liegen in diesem Ausführungsbeispiel als Drähte vor und sind zumindest teilweise im Bereich des Thermotransferklebstoffes 21 zwischen dem Patch 12 und dem Trägermaterial 11 nicht isoliert. Es können auch gänzlich unisolierte Drähte als Leitelemente 31, 32 verwendet werden, oder die Drähte werden vor dem Verkleben im Bereich des Thermotransferklebstoffes 21 zumindest teilweise abisoliert. Durch den elektrisch leitenden Thermotransferklebstoff 21, entsteht eine elektrische Verbindung zwischen den Leitelementen 31, 32, auch wenn sich die Enden der Drähte nicht berühren.

Zur Herstellung einer solchen elektrischen Verbindung können die Leitelemente 31, 32 (hier Drähte) mit zumindest teilweise abisolierten Enden auf das Trägermaterial 11 aufgelegt werden. Auf die Enden der Leitelemente 31, 32 wird dann der Patch 12 aufgelegt, der auf der dem Trägermaterial 11 zugewandten Seite mit einem elektrisch leitenden Thermotransferklebstoff beschichtet ist, beispielsweise durch Extrusion, Kaschierung, Pastenauftrag, etc.). Der Patch 12 wird daraufhin unter Druck und Temperatur (oberhalb der Schmelztemperatur des verwendeten Thermotransfermaterials) gegen das Trägermaterial 11 gepresst. Alternativ und gleichwertig könnte anstelle einer Beschichtung mit Thermotransferklebstoff 21 auch ein separater Klebstoffpatch (als Netz, Gewebe, Folie, etc.) zwischen dem Patch 12 und dem Trägermaterial 11 eingelegt werden. Dabei könnte auch auf den Patch 12 auch gänzlich verzichtet werden. Der Thermotransferklebstoff schmilzt dadurch auf und fließt um die Leitelemente 31, 32 und verbindet sich auch mit dem Trägermaterial 11 und gegebenenfalls auch mit dem Patch 12. Nach dem Aushärten des Thermotransferklebstoffes entsteht eine sicherte, dauerhafte elektrische Verbindung zwischen den Leitelementen 31, 32. Gleichzeitig werden dadurch die Leitelemente 31, 32 sicher und dauerhaft mechanisch auf dem Trägermaterial 11 fixiert.

In Fig.2 bildet der Patch 12 selbst ein Leitelement 31 aus. Dazu ist der Patch 12 selbst elektrisch leitfähig. Geeignete Werkstoffe für einen solchen elektrisch leitfähigen Patch 12 sind bekannt, es könnte z.B. leitendes Silikon sein, aber auch ein Metallgewebe oder ein Gewebe aus einem metallisierten Garn. Der Patch 12 könnte auch ein Metallstück, beispielsweise aus Kupfer oder Aluminium, oder ein elektrisch leitend beschichtetes Trägerelement sein. In diesem Fall ist das Leitelement 32 flächig ausgebildet und bildet z.B. eine Elektrode aus. Wie in Fig.1 stellt der leitende Thermotransferklebstoff 21 eine elektrische Verbindung her, nun aber zwischen dem Leitelement 31 und dem flächigen Leitelement 32, das als Patch 12 vorliegt. Wird nun ein Gegenstand 41 gegen das Leitelement 32 gedrückt entsteht eine elektrisch leitende Verbindung vom Gegenstand 41 zum Leitelement 31. Hierfür ist der Patch 12 im Bereich des Thermotransferklebstoffes 21 elektrisch leitend ausgeführt und elektrisch leitend mit einem elektrisch leitenden Oberflächenbereich an einer dem Trägermaterial 11 abgewandten Oberfläche des Patches 12 verbunden. Am einfachsten kann das realisiert werden, wenn die gesamte Oberfläche des Patches 12 oder der gesamte Patch 12 elektrisch leitend ausgeführt ist. Der Gegenstand 41 kann vielerlei Gestalt haben, es kann sich beispielsweise um den Kontakt einer Batterie handeln, dann könnte man eine Elektronik in einem Smarten Textil mit Energie versorgen. Es könnte aber auch die Überprüfung der Kontaktierung des Gegenstandes 41 überprüft werden, so dass ein Smartes Textil mitunter auch in einer sehr technischen Anwendung detektieren kann ob der Gegenstand 41 ordnungsgemäß kontaktiert ist.

Der Patch 12 könnte auch aus einem magnetisch leitfähigen Material ausgeführt sein und der Gegenstand 41 könnte einen Magnet umfassen, so dass eine elektrische und gleichzeitige mechanische Kopplung zwischen dem textilen Trägermaterial 11 und dem Gegenstand 41 hergestellt werden kann. Der Gegenstand 41, z.B. eine Batterie oder ein Batteriekasten, könnte somit mittels Magneten mechanisch an ein Textil "aufgeschnappt" werden und gleichzeitig eine elektrische Verbindung herstellen.

Der menschliche Körper kann elektrische Ströme auch leiten. Der Gegenstand 41 könnte daher auch ein nacktes Körperteil einer Person sein. Man kann dann mittels dem Leitelement 32 von einem Stück Haut als Gegenstand 41 eine elektrische Spannung abgreifen. So kann beispielsweise ein EKG (Elektrokardiogramm) Kontakt, oder ein anderer Kontakt zur Erfassung einer über die Haut erfassbaren physiologischen Größe eines Menschen, mittels des Leitelements 32 realisiert werden.

Der Thermotransferklebstoff 21 kann dabei wie im Ausführungsbeispiel nach Fig.1 entweder auf dem Patch 12 aufgebracht sein oder als separater Klebstoffpatch verwendet werden. Die Herstellung der elektrisch leitenden Verbindung kann wie im Ausführungsbeispiel nach Fig.1 erfolgen, also wieder mittels Druck und Temperatur.

Fig.3 zeigt eine Leuchtdiode 51 als elektronisches Bauteil 52 die in einen Patch 12 integriert ist. Dazu ragen die Anschlusspins 53a, 53b der Leuchtdiode 51 auf die dem Trägermaterial 11 zugewandte Seite durch den Patch 12 durch. Wird der Patch 12 vor seiner Endmontage auf dem textilen Trägermaterial 11 von hinten, beispielsweise mittels Siebdruckverfahren, so bedruckt, dass Bereiche 26 mit leitfähigem Thermotransferkleber 21 entstehen, getrennt von zumindest einem Bereich 27 mit nicht leitfähigem Thermotransferkleber 22, so können mit einem Thermotransfervorgang mehrere elektrische Verbindungen gleichzeitig hergestellt werden. Im gezeigten Ausführungsbeispiel ist das elektrische Leitelement 31 über einen leitenden Thermotransferkleber 21 mit dem ersten Anschlusspin 53a der Leuchtdiode 51 verbunden und ein zweites elektrische Leitelement 32 über den zweiten Bereich des leitenden Thermotransferklebers 21 mit dem zweiten Anschlusspin 53b der Leuchtdiode 51, wodurch zwei getrennte elektrische Verbindungen hergestellt werden. Der Patch 12 mit der Leuchtdiode 51, oder einem anderen elektronischen oder elektrischen Bauteil, und den verschiedenen Bereichen 26, 27 aus leitendem 21 und nichtleitendem 22 Thermotransferkleber stellt de-facto eine aufbügelbare Leuchtdiode 51 dar.

Dadurch, dass die verschiedenen Bereiche 26, 27 eines Thermotransferklebers 21, 22 mittels Siebdruckverfahren aufgebracht werden können, sind nahezu beliebig komplizierte Strukturen denkbar. Hierbei kann ein elektrisch leitender Thermotransferklebstoff auch mit einem elektrischen nichtleitenden Thermotransferklebstoff, oder umgekehrt, zumindest teilweise überdruckt werden. Ganze elektronische Schaltungen mit verschiedenen elektronischen Bauelementen (Dioden, Transistoren, etc.) und elektrischen Bauelementen (Widerstände, Kapazitäten, Induktivitäten, etc.) auf dem Patch 12 könnten so realisiert werden. Auch Bauelemente mit mehr als zwei Anschlusspins könnten auf diese Weise angeschlossen oder in eine elektrische Schaltung integriert werden. Ein Patch 12 mit aufgedruckten Strukturen wird so die Leiterplatte der Smart Textilindustrie. So wie eine Leiterplatte könnte ein Patch 12 vor dem Thermotransferverfahren zur Herstellung der elektrischen Verbindungen mittels eines Bestückungsautomaten mit den benötigen Bauelementen bestückt werden und danach auf das Trägermaterial 11 in richtiger Ausrichtung zu dem Leitelementen 31, 32 aufgelegt werden.

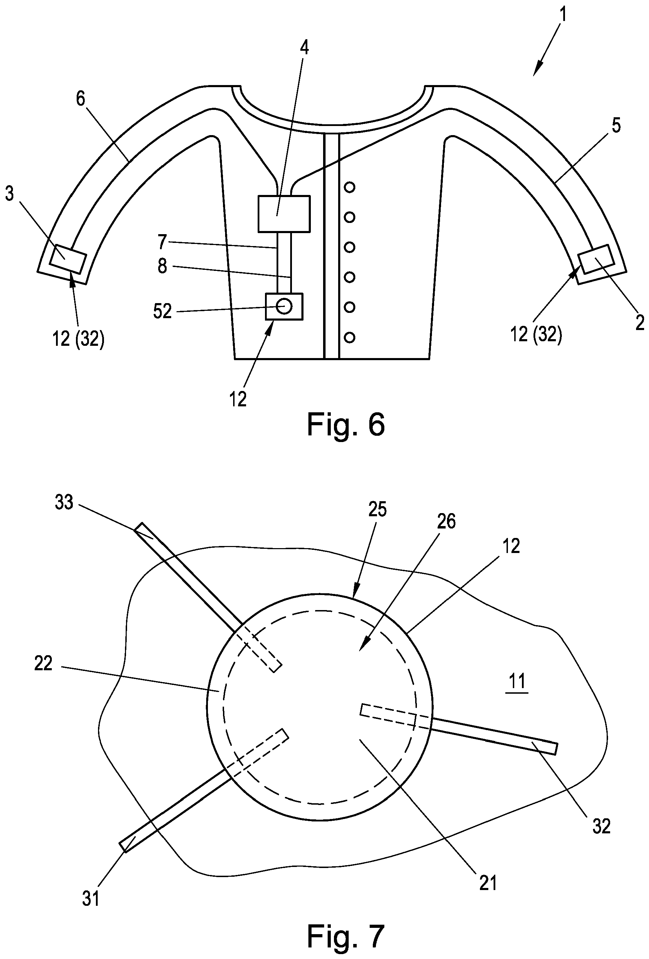

Die Verwendung von elektrisch leitendem Thermotransferklebstoff 21 und elektrisch nicht leitendem Thermotransferklebstoff 22 auf einem Patch 12 könnte aber auch noch anderweitig genutzt werden. Beispielsweise könnte die Außenkante des Patches 12 über den Umfang durchgehend einen Bereich 25 mit elektrisch nicht leitendem Thermotransferklebstoff 22 ausbilden und innerhalb dieses äußeren durchgehenden Bereich 25 ein Bereich 26 mit elektrisch leitendem Thermotransferklebstoff 21 vorgesehen sein, in dem dann die benötigten elektrischen Verbindungen hergestellt werden, wie in der Fig.5 oder Fig.7 angedeutet. Damit kann der innere elektrisch leitende Bereich 26 mit leitfähigen Thermotransferklebstoffes 21 nach außen hin elektrisch isoliert werden, beispielsweise zum Schutz gegen unbeabsichtigte elektrische Kontaktierung durch Feuchtigkeit. Ein derartiger äußerer Bereich 25 aus elektrisch nichtleitendem Thermotransferklebstoff 22 kann auch mit einer Ausführung wie im Zusammenhang mit der Fig.3 beschrieben verwendet werden. In diesem Zusammenhang kann auch der Patch 12 selbst im dem Trägermaterial 11 abgewandten Bereich und/oder das Trägermaterial 11 zumindest im Bereich des Patches 12 wasserdicht ausgeführt sein, um auch dort einer unbeabsichtigten elektrischen Kontaktierung durch Feuchtigkeit vorzubeugen Diese wasserdichte Ausführung eines Patches 12 kann natürlich auch in den anderen Ausführungsbeispielen angewendet werden.

Die Thermotransferklebstoffe 21, 22 in den verschiedenen Bereichen 25, 26, 27 sind dabei wie zum Ausführungsbeispiel nach Fig.1 beschrieben vorzugsweise vor der Anwendung des Thermotransferverfahrens auf dem Patch 12 aufgebracht, vorzugsweise in einem Druckverfahren. Die Herstellung der elektrisch leitenden Verbindungen kann wie im Ausführungsbeispiel nach Fig.1 erfolgen, also wieder mittels Druck und Temperatur

Fig.4 zeigt einen Schnitt durch einen Patch 12 über einem Leitelement 31 das im Bereich des Thermotransferklebstoffs 21 zusätzlich rundum mit einer elektrischen Isolierung 35 versehen ist. Das Leitelement 31 mit seiner Isolierung 35 kann ein ganz normaler isolierter Draht sein, nur ist die Isolierung 35 aus einem Material gefertigt, das einen Schmelzpunkt in der Größenordnung, oder sogar etwas unterhalb, der Reaktionstemperatur des Thermotransferklebstoffs 21 hat. Hierbei ist lediglich sicherzustellen, dass die Isolierung 35 während des Thermotransferverfahrens schmilzt. Vor der Aufbringung des Patches 12 auf den Trägermaterial11 war das Leitelement 31 durch die Isolierung 35 elektrisch isoliert. Beim Vorgang des Herstellen der elektrischen Verbindung mit einem zweiten Leitelement 32 durch das Thermotransferverfahren in einer Thermotransferpresse wurde aber die Isolierung 35 im Bereich des Thermotransferklebstoffs 21 weggeschmolzen und bekommt somit elektrischen Kontakt zum elektrisch leitfähigen Thermotransferklebstoff 21. Beim üblichen Druck beim Thermotransferpressen fließt die Isolierung 35 im erwärmten Bereich unter dem Patch 12 weg, sodass trotz der Isolierung 35 eine elektrische Verbindung hergestellt werden kann. Damit müsste das Leitelement 31 vor der Herstellung der elektrischen Verbindung nicht abisoliert werden, was die Herstellung deutlich vereinfacht.

Die Isolierung 35 des Leitelements 31 ist vorzugsweise aus einem Material gefertigt, das einen hinsichtlich des Thermotransferklebstoffes vergleichsweise niedrigen Schmelzpunkt aufweist. Polybuthen ist beispielsweise so ein Material. Der Schmelzpunkt von Polybuthen liegt bei ca. 135 °C, das Thermotransferverfahren kann beispielsweise bei 150 °C durchgeführt werden. Wird ein Leitelement 31 mit einer Polybuthenisolierung mittels Thermotransferverfahren verbunden, wird im gleichen Arbeitsgang die Isolierung 35 des Leitelements 31 weggeschmolzen.

Die Herstellung der elektrischen Verbindung in der Fig.4 könnte dadurch unterstützt werden, indem zwischen Leitelement 31 und dem Trägermaterial 11 und/oder zwischen dem Leitelement 31 und dem Patch 12 blanke elektrisch leitende Drähte 38 im Wesentlichen (in einem Winkel ≥25°, vorzugsweise 45 bis 90°) quer zum Leitelement 32 angeordnet werden.

Die Drähte 38 können als einzelne Drähte oder als Drahtgeflecht oder als Drahtgewebe oder als Drahtgitter vorliegen. Dadurch, dass die Drähte 38 nicht isoliert sind, haben sie eine sehr gute elektrische Verbindung zum leitenden Thermotransferklebstoff 21. Beim Verpressen im Thermotransferverfahren werden die Drähte 38 und das Leitelement 31 punktuell besonders stark zusammengedrückt, wodurch die geschmolzene Isolation 35 in diesem Bereich besser verdrängt wird. Das Leitelement 31 kann dadurch einen besonders guten Übergangswiderstand zu den Drähten 38 und damit auch zum leitenden Thermotransferklebstoff 21 erhalten.

Die Thermotransferpresse zur Durchführung des Thermotransferverfahrens kann derart ausgerüstet sein, um zumindest zeitweise während des Thermotransferverfahrens auch ein hochfrequentes Magnetfeld zu erzeugen, um zumindest im Bereich eines elektrisch isolierten Leitelements 31 eine zusätzliche lokale Erwärmung hervorzurufen und dadurch bei der Herstellung der elektrischen Verbindung die Isolierung vom Leitelement 31 noch besser wegzuschmelzen. Um das zu unterstützen kann im Bereich der Isolierung 35 im Bereich der herzustellenden elektrischen Verbindung eine elektrisch leitende Struktur (z.B. als Folie oder auch als Aufdruck auf dem Trägermaterial 11 oder einem Patch 12) aus einer Vielzahl von geschlossenen elektrischen Leitern (z.B. Drahtringe oder Drahtschleifen) vorgesehen sein. Diese geschlossenen Leiter bilden dann Kurzschlussringe aus, in die das hochfrequente Magnetfeld einen Strom induziert, was zur Erwärmung der elektrischen Leiter führt. Damit kann lokal sehr genau zusätzlich Wärme erzeugt werden, um die Isolierung 35 abzuschmelzen. Auf diese Weise könnte auch eine Isolierung 35 verwenden, deren Schmelzpunkt über der Reaktionstemperatur des Thermotransferklebstoffes 21 liegt.

Die Verwendung von isolierten Leitelementen 31 wie in Fig.4 beschrieben ist natürlich in jedem Ausführungsbeispiel auch Fig.1, 2, 3 und 5 denkbar.

Im Ausführungsbeispiel nach der Fig.5 sind im textilen Trägermaterial 11 neben herkömmlichen Fasern 36 aus textilem Material auch zumindest eine elektrisch leitende Faser 34, z.B. in Form eines Metallgarns oder eines metallisierten Garns, eingearbeitet. Die elektrisch leitende Faser 34 bildet damit ein elektrisches Leitelement 31 aus, das mit einem zweiten Leitelement 32 (entweder ein Draht (oder ähnliches) oder der Patch 12 selbst) über den elektrisch leitenden Thermotransferklebstoff 21 elektrisch leitend verbunden werden soll. Beim Thermotransferverfahren zur Herstellung der elektrischen Verbindung wird der Thermotransferklebstoff 21 zähfließend und wird damit aufgrund des Druckes auch in das textile Trägermaterial 11 hineingedrückt (das trifft natürlich auch auf die anderen Ausführungsbeispiele zu, in denen das nicht beschrieben oder dargestellt wurde). Der Thermotransferklebstoff 21 kontaktiert damit auch die elektrisch leitende Faser 34 im Trägermaterial 11, womit ebenso eine elektrische Verbindung zum anderen Leitelement 32 hergestellt werden kann. Auch das kann natürlich in anderen Ausführungsbeispielen, z.B. nach der Fig.3, angewendet werden.

Selbstverständlich lassen sich mit der erfindungsgemäßen elektrischen Verbindung auch mehr als zwei Leitelemente 31, 32 mit dem elektrisch leitenden Thermotransferklebstoff 21 elektrisch miteinander verbinden, wie in Fig.7 dargestellt. Dabei könnte zusätzlich auch noch der Patch 12 wie beschrieben elektrisch leitend ausgeführt sein.

Für die Erfindung ist es an sich unerheblich woher die Leitelemente 31, 32 kommen, wie diese am Trägerelement 11 verlegt oder angeordnet sind oder womit diese am anderen Ende verbunden sind. Diese können auch frei liegend verlegt sein oder können auf dem Trägermaterial 11 selbst befestigt sein. Auch eine Anordnung zwischen zwei Lagen eines Trägermaterials ist natürlich denkbar. Wie die Leitelemente 31, 32 außerhalb der elektrischen Verbindung verlaufen ist nicht Gegenstand der Erfindung. Sie könnten in das textile Trägermaterial 11 eingearbeitet, aufgebracht (geklebt, geheftet, genäht oder sogar mittels Siebdruck oder ähnlichen Verfahren aufgebracht) sein oder gar nicht mit dem textilen Trägermaterial 11 verbunden sein. In einer besonders vorteilhaften Ausgestaltung wird zumindest ein Leitelement 31, 32 als Leiterbahn auf das Trägerelement 11 gedruckt, geplottet oder geklebt.

Fig.6 zeigt ein Beispiel eines intelligenten Kleidungsstücks 1 (Smart Textile) mit Hautelektroden 2, 3 an den Ärmelbünden, um ein elektrisches Hautpotential abzugreifen. Die Hautelektroden 2, 3 sind als elektrisch leitende Patch 12 als Leitelement 32 wie in Fig.2 beschrieben ausgeführt. Die beiden Hautelektroden 2, 3 sind über Drähte 5, 6 als Leitelemente 31 mit einer Auswerteeinheit 4 (Mikroprozessor mit Software) verbunden. Die elektrischen Verbindungen zwischen Patch 12 (Leitelement 32) und Draht 5, 6 (Leitelement 31) erfolgen wie beschrieben mittels Thermotransferverfahren mit einem elektrisch leitenden Thermotransferklebstoff 21. Auf einem weiteren Patch 12 ist eine Leuchtdiode 51 wie in Fig.3 beschrieben angeordnet, die über Drähte 7, 8 (Leitelement 31, 32) ebenfalls mit der Auswerteeinheit 4 verbunden ist. Die elektrische Verbindung zwischen Patch 12 und den Drähten 7, 8 und die Ausgestaltung des Patches 12 erfolgt wie zu Fig.3 beschrieben. In diesem Beispiel kann eine elektrische Spannung zwischen den beiden Hautelektroden in der Auswerteeinheit 4 ausgewertet werden. Übersteigt die Spannung einen vorgegebenen Grenzwert, wird das über die Leuchtdiode 51 angezeigt. Die Herstellung des intelligenten Kleidungsstückes 1 kann sehr einfach und schnell erfolgen.

Um die Herstellung einer elektrischen Verbindung zu erleichtern, kann auf der dem Trägermaterial 11 zugewandten Seite des Patches 12 und/oder auf der dem Patch 12 zugewandten Seite des Trägermaterials 11 ein bei Raumtemperatur klebender Kleber vorgesehen sein, um den Patch 12 für das Thermotransferverfahren provisorisch zu fixieren.

Ein solcher Kleber ist vorzugsweise nur leicht und auch nach mehrmaliger Applikation des Patches 12 auf dem Trägermaterial 11 noch immer haftend, um den Patch 12 einfach ordnungsgemäß am Trägermaterial 11 ausrichten zu können. Ein solcher Kleber ist vorzugsweise nicht vollflächig am Patch 12 vorgesehen, sondern nur partiell und in sehr geringer Menge bzw. Grammatur. Ferner hat ein solcher Kleber vorzugsweise eine Schmelztemperatur, die unterhalb der Schmelztemperatur des Thermotransferklebstoffes 21 liegt, um das Thermotransferverfahren und die Herstellung der elektrischen Verbindung nicht zu beeinflussen.

## Patentansprüche

1. Verfahren zur Herstellung einer elektrisch leitenden Verbindung zwischen einem ersten Leitelement (31) und einem zweiten Leitelement (32) auf einem textilen Trägermaterial (11), wobei das erste und zweite Leitelement (31, 32) auf dem Trägermaterial (11) angeordnet werden, im Bereich des ersten und zweiten Leitelements (31, 32) ein elektrisch leitender Thermotransferklebstoff (21) angeordnet wird und der Thermotransferklebstoff (21) bis zur Fließbarkeit aufgeschmolzen wird, sodass der fließbare Thermotransferklebstoff (21) das erste und zweite Leitelement (31, 32) zumindest teilweise umgibt und sich mit dem Trägermaterial (11) verbindet und das erste Leitelement (31) und das zweite Leitelement (32) nach dem Aushärten des Thermotransferklebstoffes (21) über den Thermotransferklebstoff (21) elektrisch miteinander verbunden werden, **dadurch gekennzeichnet, dass** ein Patch (12) mit einem auf einer dem Trägermaterial (11) zugewandten Seite aufgetragenen elektrisch leitenden Thermotransferklebstoff (21) oder ein Patch (12) mit einem Klebstoffpatch aus elektrisch leitendem Thermotransferklebstoff (21) zwischen Patch (12) und Trägermaterial (11) verwendet wird, wobei der Patch (12) auf das Ende des ersten Leitelements (31) und des zweiten Leitelementes (32) und auf das Trägermaterial (11) aufgelegt wird, bevor der Thermotransferklebstoff (21) unter Druckeinwirkung aufgeschmolzen wird, um die elektrische Verbindung herzustellen oder ein Patch (12) mit einem auf einer dem Trägermaterial (11) zugewandten Seite aufgetragenen elektrisch leitenden Thermotransferklebstoff (21) oder ein Patch (12) mit einem Klebstoffpatch aus elektrisch leitendem Thermotransferklebstoff (21) zwischen Patch (12) und Trägermaterial (11) als zweites Leitelement (32) verwendet wird, wobei der Patch (12) an einer dem Trägermaterial (11) zugewandten Seite elektrisch leitend ausgeführt wird und der Patch (12) auf das Ende des ersten Leitelements (31) und auf das Trägermaterial (11) aufgelegt wird, bevor der Thermotransferklebstoff (21) unter Druckeinwirkung aufgeschmolzen wird, um die elektrische Verbindung herzustellen.

2. Verfahren nach Anspruch 1, **dadurch gekennzeichnet, dass** der Patch (12) an der dem Trägermaterial (11) abgewandten Seite elektrisch leitfähig ausgeführt wird und die dem Trägermaterial (11) abgewandte Seite mit der dem Trägermaterial (11) zugewandten Seite elektrisch miteinander verbunden wird.

3. Verfahren nach Anspruch 1, **dadurch gekennzeichnet, dass** der Patch (12) auf einer dem Trägermaterial (11) zugewandten Seite einen ersten und einen zweiten Bereich (26) aus elektrisch leitendem Thermotransferklebstoff (21) und einen dritten Bereich (27) aus elektrisch nichtleitendem Thermotransferklebstoff (22) aufweist, und der Patch (12) mit dem ersten Bereich (26) auf das Ende des ersten Leitelements (31) und mit dem zweiten Bereich (26) auf das Ende des zweiten Leitelements (32) auf das Trägermaterial (11) aufgelegt wird, bevor die Thermotransferklebstoffe (21, 22) der Bereiche (26, 27) unter Druckeinwirkung aufgeschmolzen werden, um die elektrische Verbindung herzustellen.

4. Verfahren nach Anspruch 3, **dadurch gekennzeichnet, dass** der erste und der zweite elektrisch leitfähige Bereich (26) am Patch (12) durch den dritten elektrisch nicht leitfähigen Bereich (27) elektrisch voneinander isoliert werden.

5. Verfahren nach Anspruch 4, **dadurch gekennzeichnet, dass** am Patch (12) vor dem Auflegen auf das Trägermaterial (11) zumindest ein elektronischer oder elektrischer Bauteil (52) mit zumindest einem ersten und zweiten Anschlusspin (53a, 53b) angeordnet wird, wobei der erste Anschlusspin (53a) mit dem ersten elektrisch leitfähigen Bereich (26) elektrisch leitend verbunden wird und der zweite Anschlusspin (53b) mit dem zweiten elektrisch leitfähigen Bereich (26) elektrisch leitend verbunden wird.

6. Verfahren nach Anspruch 5, **dadurch gekennzeichnet, dass** das zumindest eine elektronische oder elektrische Bauteil (52) mittels eines Bestückungsautomaten am Patch (12) angeordnet wird.

7. Verfahren nach einem der Ansprüche 1 bis 6, **dadurch gekennzeichnet, dass** an den Außenkanten des Patches (12) über den Umfang des Patches (12) durchgehend ein elektrisch nichtleitender Thermotransferklebstoff (22) aufgetragen wird, bevor der Patch (12) zur Herstellung der elektrischen Verbindung auf das Trägermaterial (11) aufgelegt wird.

8. Verfahren nach einem der Ansprüche 1 bis 7, **dadurch gekennzeichnet, dass** zumindest ein Leitelement (31, 32) mit einer elektrischen Isolierung (35) im Bereich des elektrisch leitenden Thermotransferklebstoffes (21) verwendet wird und die Isolierung (35) bei der Herstellung der elektrischen Verbindung zumindest teilweise aufgeschmolzen wird, sodass das zumindest eine Leitelement (31, 32) elektrischen Kontakt mit dem elektrisch leitenden Thermotransferklebstoffes (21) bekommt.

9. Verfahren nach Anspruch 8, **dadurch gekennzeichnet, dass** zwischen dem Trägermaterial (11) und dem zumindest einen Leitelement (31, 32) mit Isolierung (35) und/oder zwischen dem zumindest einen Leitelement (31, 32) mit Isolierung (35) und einem Patch (12) ein elektrisch leitender Draht (38) im Wesentlichen quer zum Leitelement (31, 32) angeordnet wird, bevor die elektrische Verbindung hergestellt wird.

10. Verfahren nach einem der Ansprüche 1 bis 9, **dadurch gekennzeichnet, dass** ein elektrisch leitender Thermotransferklebstoff (21) mittels eines Druckverfahrens auf den Patch (12) aufgebracht wird.

11. Verfahren nach einem der Ansprüche 3 bis 7, **dadurch gekennzeichnet, dass** ein elektrisch nichtleitender Thermotransferklebstoff (22) mittels eines Druckverfahrens auf den Patch (12) aufgebracht wird.

12. Verfahren nach Anspruch 10 und 11, **dadurch gekennzeichnet, dass** ein elektrisch leitender Thermotransferklebstoff (21) zumindest teilweise mit einem elektrisch nichtleitenden Thermotransferklebstoff (22), oder umgekehrt, überdruckt wird.

## Claims

1. Method for producing an electrically conductive connection between a first conductive element (31) and a second conductive element (32) on a textile carrier material (11), whereas the first and second conductive elements (31, 32) are arranged on the carrier material (11), an electrically conductive thermal transfer adhesive (21) is arranged in the region of the first and second conductive element (31, 32) and the thermal transfer adhesive (21) is melted until it is flowable, such that the flowable thermal transfer adhesive (21) at least partially surrounds the first and second conductive element (31, 32) and connects to the carrier material (11), and the first conductive element (31) and the second conductive element (32) are electrically connected to one another via the thermal transfer adhesive (21) after the thermal transfer adhesive (21) has hardened, **characterized in that** a patch (12) comprising an electrically conductive thermal transfer adhesive (21) applied to a side facing the carrier material (11) or a patch (12) and an adhesive patch made of electrically conductive thermal transfer adhesive (21) between the patch (12) and carrier material (11) is used, whereas the patch (12) is placed on the end of the first conductive element (31) and the end of the second conductive element (32) and on the carrier material (11) before the thermal transfer adhesive (21) is melted under pressure in order to produce the electrical connection or a patch (12) comprising an electrically conductive thermal transfer adhesive (21) applied to a side facing the carrier material (11) or a patch (12) and an adhesive patch made of electrically conductive thermal transfer adhesive (21) between the patch (12) and the carrier material (11) is used as the second conductive element (32), whereas the patch (12) is electrically conductive on a side facing the carrier material (11) and the patch (12) is placed on the end of the first conductive element (31) and on the carrier material (11) before the thermal transfer adhesive (21) is melted under pressure in order to produce the electrical connection.

2. Method according to claim 1, **characterized in that** the patch (12) is electrically conductive on the side facing away from the carrier material (11) and the side facing away from the carrier material (11) is electrically connected to the side facing the carrier material (11).

3. Method according to claim 1, **characterized in that** the patch (12) is having a first and a second region (26) made of electrically conductive thermal transfer adhesive (21) and comprising a third region (27) made of electrically non-conductive thermal transfer adhesive (22) on a side facing the carrier material (11), and the patch (12) is placed by the first region (26) on the end of the first conductive element (31) and by the second region (26) on the end of the second conductive element (32) on the carrier material (11) before the thermal transfer adhesives (21, 22) of the regions (26, 27) are melted under pressure in order to produce the electrical connection.

4. Method according to claim 3, **characterized in that** the first and the second electrically conductive region (26) on the patch (12) are electrically insulated from one another by the third electrically non-conductive region (27).

5. Method according to claim 4, **characterized in that** at least one electronic or electrical component (52) comprising at least one first and second connection pin (53a, 53b) is arranged on the patch (12) before it is placed on the carrier material (11), whereas the first connection pin (53a) is connected in an electrically conductive manner to the first electrically conductive region (26) and the second connection pin (53b) is connected in an electrically conductive manner to the second electrically conductive region (26).

6. Method according to claim 5, **characterized in that** the at least one electronic or electrical component (52) is arranged on the patch (12) by means of an automatic placement machine.

7. Method according to any of claims 1 to 6, **characterized in that** an electrically non-conductive thermal transfer adhesive (22) is applied to the outer edges of the patch (12) continuously over the circumference of the patch (12) before the patch (12) is placed on the carrier material (11) to produce the electrical connection.

8. Method according to any of claims 1 to 7, **characterized in that** at least one conductive element (31, 32) comprising electrical insulation (35) is used in the region of the electrically conductive thermal transfer adhesive (21) and the insulation (35) is at least partially melted when the electrical connection is produced, so that the at least one conductive element (31, 32) makes electric contact with the electrically conductive thermal transfer adhesive (21).

9. Method according to claim 8, **characterized in that** an electrically conductive wire (38) is arranged substantially transversely to the conductive element (31, 32), between the carrier material (11) and the at least one conductive element (31, 32) comprising insulation (35) and/or between the at least one conductive element (31, 32) comprising insulation (35) and a patch (12) before the electrical connection is produced.

10. Method according to any of claims 1 to 9, **characterized in that** an electrically conductive thermal transfer adhesive (21) is applied to the patch (12) by means of a printing method.

11. Method according to any of claims 3 to 7, **characterized in that** an electrically non-conductive thermal transfer adhesive (22) is applied to the patch (12) by means of a printing method.

12. Method according to claim 10 and claim 11, **characterized in that** an electrically conductive thermal transfer adhesive (21) is at least partially overprinted with an electrically non-conductive thermal transfer adhesive (22), or vice versa.

## Revendications

1. Procédé permettant d'établir une connexion électriquement conductrice entre un premier élément conducteur (31) et un second élément conducteur (32) sur un matériau de support (11) textile, dans lequel le premier et le second élément conducteur (31, 32) sont disposés sur le matériau de support (11), une colle par transfert thermique électriquement conductrice (21) est disposée dans la zone du premier et du second élément conducteur (31, 32) et la colle par transfert thermique (21) est fondue jusqu'à fluidité, de sorte que la colle par transfert thermique (21) fluide entoure au moins partiellement le premier et le second élément conducteur (31, 32) et se lie au matériau de support (11), et le premier élément conducteur (31) et le second élément conducteur (32) sont connectés électriquement l'un à l'autre par l'intermédiaire de la colle par transfert thermique (21) après le durcissement de la colle par transfert thermique (21), **caractérisé en ce qu'**un patch (12) comportant une colle par transfert thermique électriquement conductrice (21) étalée sur un côté tourné vers le matériau de support (11) ou un patch (12) comportant un patch de colle en colle par transfert thermique électriquement conductrice (21) est utilisé entre le patch (12) et le matériau de support (11), dans lequel le patch (12) est posé sur l'extrémité du premier élément conducteur (31) et du second élément conducteur (32) et sur le matériau de support (11) avant que la colle par transfert thermique (21) ne soit fondue sous un effet de pression, afin d'établir la connexion électrique ou un patch (12) comportant une colle par transfert thermique électriquement conductrice (21) étalée sur un côté tourné vers le matériau de support (11) ou un patch (12) comportant un patch de colle en colle par transfert thermique électriquement conductrice (21) est utilisé entre le patch (12) et le matériau de support (11) comme second élément conducteur (32), dans lequel le patch (12) est réalisé de manière électriquement conductrice sur un côté tourné vers le matériau de support (11) et le patch (12) est posé sur l'extrémité du premier élément conducteur (31) et sur le matériau de support (11) avant que la colle par transfert thermique (21) ne soit fondue sous l'effet de pression afin d'établir la connexion électrique.

2. Procédé selon la revendication 1, **caractérisé en ce que** le patch (12) est réalisé de manière électriquement conductrice sur le côté opposé au matériau de support (11) et le côté opposé au matériau de support (11) et le côté tourné vers le matériau de support (11) sont connectés électriquement entre eux.

3. Procédé selon la revendication 1, **caractérisé en ce que** le patch (12) présente, sur un côté tourné vers le matériau de support (11), une première et une deuxième zone (26) en colle par transfert thermique électriquement conductrice (21) et une troisième zone (27) en colle par transfert thermique non électriquement conductrice (22), et le patch (12) est posé sur le matériau de support (11) avec la première zone (26) sur l'extrémité du premier élément conducteur (31) et avec la deuxième zone (26) sur l'extrémité du second élément conducteur (32), avant que les colles par transfert thermique (21, 22) des zones (26, 27) ne soient fondues sous l'effet de pression afin d'établir la connexion électrique.

4. Procédé selon la revendication 3, **caractérisé en ce que** la première et la deuxième zone (26) électriquement conductrice sur le patch (12) sont isolées électriquement l'une de l'autre par la troisième zone (27) non électriquement conductrice.

5. Procédé selon la revendication 4, **caractérisé en ce qu'**au moins un composant électronique ou électrique (52) comportant au moins une première et une seconde broche de raccordement (53a, 53b) est disposé sur le patch (12) avant la pose sur le matériau de support (11), dans lequel la première broche de raccordement (53a) est connectée de manière électriquement conductrice à la première zone (26) électriquement conductrice et la seconde broche de raccordement (53b) est connectée de manière électriquement conductrice à la deuxième zone (26) électriquement conductrice.

6. Procédé selon la revendication 5, **caractérisé en ce que** l'au moins un composant électronique ou électrique (52) est disposé sur le patch (12) au moyen d'un automate de montage.

7. Procédé selon l'une des revendications 1 à 6, **caractérisé en ce qu'**une colle par transfert thermique non électriquement conductrice (22) est étalée en continu sur les bords extérieurs du patch (12), sur la périphérie du patch (12), avant que le patch (12) ne soit posé sur le matériau de support (11) pour l'établissement de la connexion électrique.

8. Procédé selon l'une des revendications 1 à 7, **caractérisé en ce qu'**au moins un élément conducteur (31, 32) comportant une isolation (35) électrique est utilisé dans la zone de la colle par transfert thermique électriquement conductrice (21) et l'isolation (35) est au moins partiellement fondue lors de l'établissement de la connexion électrique, de sorte que l'au moins un élément conducteur (31, 32) obtient un contact électrique avec la colle par transfert thermique électriquement conductrice (21).

9. Procédé selon la revendication 8, **caractérisé en ce qu'**un fil (38) conducteur d'électricité est disposé sensiblement transversalement à l'élément conducteur (31, 32) entre le matériau de support (11) et l'au moins un élément conducteur (31, 32) comportant l'isolation (35) et/ou entre l'au moins un élément conducteur (31, 32) comportant l'isolation (35) et un patch (12) avant que la connexion électrique ne soit établie.

10. Procédé selon l'une des revendications 1 à 9, **caractérisé en ce qu'**une colle par transfert thermique électriquement conductrice (21) est appliquée sur le patch (12) au moyen d'un procédé d'impression.

11. Procédé selon l'une des revendications 3 à 7, **caractérisé en ce qu'**une colle par transfert thermique non électriquement conductrice (22) est appliquée sur le patch (12) au moyen d'un procédé d'impression.

12. Procédé selon les revendications 10 et 11, **caractérisé en ce qu'**une colle par transfert thermique électriquement conductrice (21) est au moins partiellement surimprimée avec une colle par transfert thermique électriquement non conductrice (22), ou inversement.
